**Europäisches Patentamt**

**European Patent Office**

**Office européen des brevets**

(19)

(11) Numéro de publication : **0 148 685
B1**

(12)
# FASCICULE DE BREVET EUROPÉEN

(45) Date de publication du fascicule du brevet :
**17.08.88**

(51) Int. Cl.⁴ : **H 03 F   1/30**

(21) Numéro de dépôt : **84402619.5**

(22) Date de dépôt : **17.12.84**

---

(54) **Montage amplificateur différentiel à courant continu, notamment pour la mesure de faibles tensions variant lentement.**

---

(30) Priorité : **21.12.83 FR 8320505**

(43) Date de publication de la demande :
**17.07.85 Bulletin 85/29**

(45) Mention de la délivrance du brevet :
**17.08.88 Bulletin 88/33**

(84) Etats contractants désignés :
**DE GB IT SE**

(56) Documents cités :
**US-A- 4 138 649
US-A- 4 298 843
ELECTRONICS INTERNATIONAL, vol. 51, no. 8, 13
avril 1978, pages 135-137, New York, US; A. KANIEL:
"Subtractor eliminates op-amp offset, commonmode errors"
PATENTS ABSTRACTS OF JAPAN, vol. 4, no. 175 (E-
36) [657], 3 décembre 1980**

(73) Titulaire : **FACOM, Société dite:
6 et 8 Rue Gustave Eiffel
F-91423 Morangis (FR)**

(72) Inventeur : **Petit, Jean-Pierre
1 Rue du Clos du Pileu
F-91120 Palaiseau (FR)**

(74) Mandataire : **Polus, Camille et al
c/o Cabinet Lavoix 2, Place d'Estienne d'Orves
F-75441 Paris Cedex 09 (FR)**

EP 0 148 685 B1

## Description

La présente invention est relative aux montages d'amplification différentiels à courant continu destinés à amplifier des signaux dont l'excursion à mesurer est relativement lente et faible et, en particulier, plus faible que la tension d'erreur introduite par les perturbations dans le montage lui-même.

Plus particulièrement, l'invention concerne un montage amplificateur destiné à amplifier le signal provenant d'un pont de mesure dans lequel est incorporé au moins un capteur d'un paramètre tel qu'un capteur de température, une jauge de contrainte ou analogue.

Actuellement, on sait réduire les influences de la température sur la dérive d'un amplificateur différentiel et augmenter le taux de rejection du mode commun de celui-ci par plusieurs artifices. Ainsi, il est connu d'utiliser deux amplificateurs opérationnels en cascade associés à un réseau d'au moins quatre résistances, mais ce montage présente l'inconvénient de présenter un gain qui dépend des valeurs des quatre résistances. En outre, ces valeurs doivent être ajustées avec une très grande précision.

Voir également le document Kaniel, Electronics International volume 51, n° 8 du 13 avril 1978, pages 135-136.

Enfin, ces amplificateurs n'ont pas une caractéristique linéaire et leur décalage (off-set) et la dérive de ce décalage restent dans des limites intolérables pour de très faibles excursions de la tension d'entrée. Un tel amplificateur n'est donc pas approprié pour être utilisé avec un pont de mesure dans lequel, en général, le domaine de tension différentielle intéressant se situe près de la tension nulle, c'est-à-dire lorsqu'il y a quasi-équilibre du pont.

Il est également connu d'utiliser des amplificateurs stabilisés par un chopper dont une description peut être trouvée dans l'ouvrage « la Technique de l'Ingénieur » section E 1262, pages 4 et 5. Cependant, ces montages sont d'un prix de revient élevé, ont une consommation importante et ne possédant pas d'équivalent chez les différents fabriquants.

L'invention a pour but de proposer un montage amplificateur du type général indiqué ci-dessus, permettant avec un nombre minimal de composants, d'ailleurs de types couramment utilisés d'obtenir une dérive extrêmement faible voire nulle en température, une faible consommation, un taux élevé de rejection en mode commun, une faible consommation ainsi qu'une possibilité de réglage de gain extrêmement commode.

Le montage amplificateur différentiel à courant continu, notamment pour la mesure de faibles tensions variant lentement, selon l'invention, du type comportant deux amplificateurs opérationnels en cascade dont les entrées non inverseuses sont raccordées aux bornes d'entrée du montage, le premier amplificateur étant rebouclé sur son entrée inverseuse, tandis que sa sortie est connectée à l'entrée inverseuse du second amplificateur, celui-ci comprenant une boucle de réaction qui en détermine un gain prédéterminé, est caractérisé en ce que les entrées non inverseuses des deux amplificateurs sont connectées auxdites bornes d'entrée du montage par l'intermédiaire de moyens de commutation pour permettre sélectivement l'inversion de polarité de cette connexion, en ce qu'il comprend en outre des moyens pour déterminer des cycles de fonctionnement successifs comprenant un cycle de mesure et un cycle de calcul, une mémoire pour mémoriser pendant chaque cycle de fonctionnement le signal de sortie du second amplificateur résultant d'un signal d'entrée reçu dans une première position des moyens de commutation et un circuit de calcul qui reçoit lorsque lesdits moyens de commutation sont dans une seconde position le signal de sortie dudit second amplificateur pour opérer durant le cycle de calcul, la soustraction du signal mémorisé et du second signal de sortie du second amplificateur, en ce que la sortie dudit second amplificateur est raccordée auxdits moyens de calcul et à ladite mémoire par l'intermédiaire d'un convertisseur analogique/numérique, et en ce que les moyens de calcul et la mémoire sont des composants numériques commandés par une horloge.

L'invention sera mieux comprise à l'aide de la description qui va suivre, donnée uniquement à titre d'exemple et faite en se référant aux dessins annexés, sur lesquels :

— la Fig. 1 est un schéma d'un exemple de réalisation du montage amplificateur suivant l'invention dans le cas où il est chargé d'amplifier le signal de mesure d'un pont comprenant des jauges de contraintes ;

— la Fig. 2 est un diagramme des temps illustrant le fonctionnement du montage représenté sur la Fig. 1.

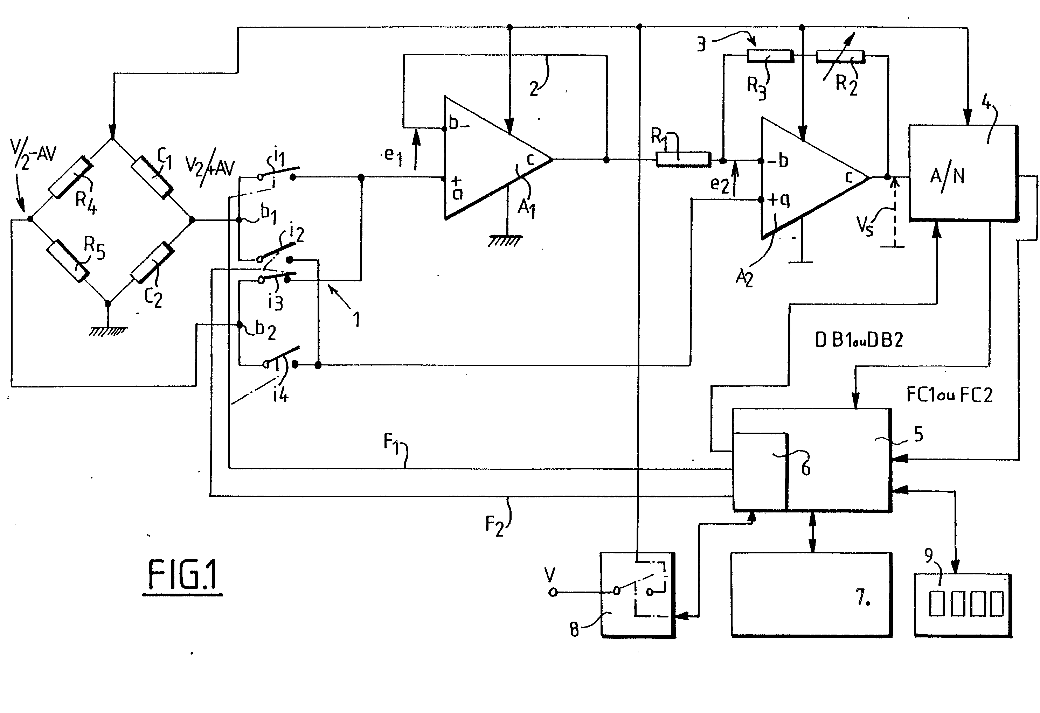

Dans le mode de réalisation représenté à la Fig. 1, le montage amplificateur suivant l'invention comprend un premier amplificateur opérationnel A1 auquel est branché en cascade un second amplificateur opérationnel A2.

Plus précisément, l'entrée a non inverseuse de l'amplificateur A1 est reliée à un groupe 1 d'interrupteurs d'inversion, tandis que son entrée b inverseuse est reliée à sa borne de sortie c par une boucle 2 de réaction directe.

L'entrée non inverseuse a de l'amplificateur A2 est reliée également au groupe 1 d'interrupteurs d'inversion, tandis que son entrée inverseuse b est connectée à la sortie c du premier amplificateur A1 à travers une résistance R1. L'amplificateur A2 est pourvu d'une boucle de réaction 3 comprenant une résistance R2 de réglage de gain et une résistance R3. La sortie de cet amplificateur A2 est connectée à un convertisseur analogique-numérique 4.

Le groupe 1 d'interrupteurs d'inversion comporte quatre interrupteurs i1 à i4 qui peuvent être réalisés commodément à l'aide de transistors à effet de champ. Ils constituent un inverseur bipolaire de la tension différentielle qui lui est fournie sur les bornes d'entrée b1 et b2 par un pont de mesure qui dans l'exemple décrit ici est chargé de mesurer un paramètre dont on désire étudier l'évolution. Ce paramètre peut être quelconque tel qu'une température, une pression, une contrainte mécanique ou autre, mesuré par exemple à l'aide d'une résistance variant avec l'évolution du paramètre. Une application pratique de l'invention peut ête la mesure d'un couple de serrage dans une clé dynamométrique électrique pourvue de jauges de contrainte montées dans l'une des branches du pont. Celui-ci comporte donc dans ce cas deux jauges C1 et C2 ainsi que deux résistances fixes et égales à R4 et R5, bien que l'on puisse utiliser également quatre jauges.

On notera toutefois que le montage amplificateur suivant l'invention peut être utilisé avec d'autres sources de signaux qu'elles se présentent sous forme d'un pont de mesure ou en tant qu'impédance variable simple.

L'amplificateur A1 étant rebouclé en gain unité, il assure une impédance d'entrée élevée du montage.

On suppose que dans l'exemple, la tension d'alimentation du pont étant égale à V, lors d'un déséquilibre par variation des jauges C1 et C2, il apparaît aux bornes de sortie du pont une tension qui est égale respectivement à $V/2 + \Delta V$ et $V/2 - \Delta V$.

Si on appelle e1, la tension de faux zéro et la dérive de cette tension pour l'amplificateur A1, et e2 la même perturbation en ce qui concerne l'amplificateur A2 et si, par ailleurs R2 + R3 = R, il vient, selon la position des interrupteurs i1 à i4 :

$$V_s = V/2 + \frac{R}{R_1}(e_2 - e_1) + e_2 \pm \Delta V \left( \frac{2R}{R_1} + 1 \right)$$

Dans cette équation, le terme

$$\Delta V \left( \frac{2R}{R_1} + 1 \right)$$

est le terme utile rendant compte de l'évolution du paramètre à mesurer, tandis que les termes V/2 et surtout

$$\frac{R}{R_1}(e_2 - e_1) + e_2$$

sont inutiles, ce dernier terme étant dû aux défauts inévitables des amplificateurs. V/2 dépend de la source d'alimentation dont on ne peut également maîtriser la valeur que moyennant une plus grande complexité du circuit.

Le montage amplificateur suivant l'invention comprend également un circuit de calcul 5 pourvu d'un circuit d'horloge 6, d'une mémoire 7, d'un interrupteur d'alimentation 8 et d'un circuit d'utilisation 9 qui peut être un afficheur à diodes électroluminescentes, par exemple.

L'interrupteur d'alimentation 8 qui est raccordé à une source d'alimentation $V_{alim}$ est commandé par un signal de cycle SC qui lui est appliqué par le circuit d'horloge 6. L'interrupteur d'alimentation est raccordé au pont de mesure, aux amplificateurs A1 et A2 et au convertisseur 4, de sorte que ces composants ne sont alimentés que lorsque l'interrupteur 8 est fermé. Le rapport cyclique du signal de cycle SC est choisi de manière à n'alimenter ces composants que lorsqu'il est procédé à une mesure, seuls le circuit de calcul, la mémoire 7 et l'afficheur 9 étant alimentés en permanence. Il en résulte une consommation extrêmement faible de l'ensemble du montage.

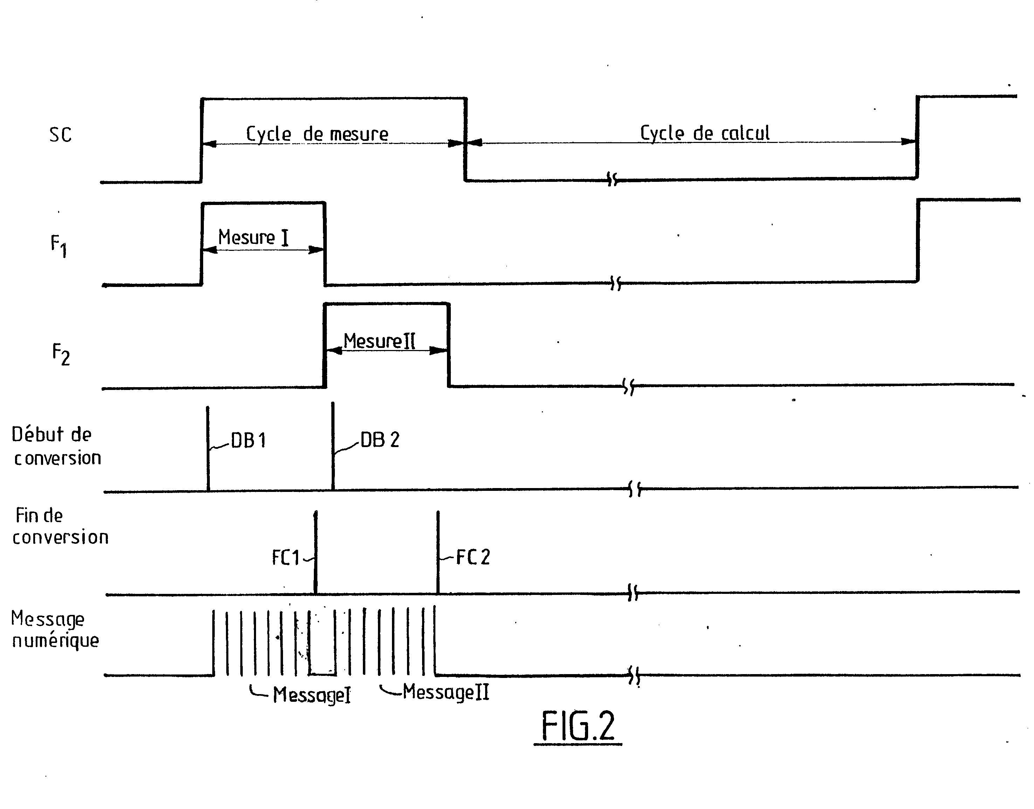

Durant chaque intervalle de fermeture de l'interrupteur 8, c'est-à-dire dans le cas décrit ici (Fig. 2) lorsque le signal de cycle est haut, le circuit d'horloge produit successivement un signal de fermeture F1 pour les interrupteurs i1 et i4 et un signal de fermeture pour les interrupteurs i2 et i3.

Pendant que le signal de fermeture F1 est haut, l'amplificateur A2 applique au convertisseur 4 une tension VS1 de la forme de l'équation donnée ci-dessus dans laquelle le terme

$$\Delta V \left( \frac{2R}{R_1} + 1 \right)$$

est négatif tandis que lorsque le signal de fermeture F2 est haut, le convertisseur reçoit une tension $V_{S1}$ qui présente le même terme mais avec un signe positif.

Le convertisseur analogique/numérique 4 est commandé durant chaque mesure pour opérer la conversion en numérique de la tension $V_{S1}$ ou $V_{S2}$ sous la commande d'un signal de début de conversion DB1 ou DB2, fourni par le circuit d'horloge 6, tandis que le résultat de chaque conversion est transféré au circuit de calcul 5 par un signal de fin de conversion FC1 ou FC2 que le convertisseur 4 applique à ce même circuit de calcul 5.

Durant la période où le signal SC est bas, le circuit de calcul 5 opère la soustraction de la tension $V_{S1}$

**0 148 685**

préalablement stockée dans la mémoire 7 et de la tension $V_{S2}$ avec :

$$V_{S1} - V_{S2} = 2\,\Delta V \left( \frac{2\,R}{R_1} + 1 \right)$$

On voit que dans le résultat de cette soustraction, toute composante parasite engendrée par les tensions de faux zéro et leur dérive thermique est éliminée. Par ailleurs, on voit que le gain du montage ne dépend que du rapport de deux résistances R et R1 ce qui en pratique signifie que ce gain peut facilement être réglé en décomposant la résistance R en une résistance fixe R3 et une résistance réglable R2, comme représenté à titre d'exemple sur la Fig. 1.

A titre d'exemple, le rapport cyclique de l'interrupteur 8 (signal SC) peut être très faible c'est-à-dire 4 ms d'intervalle actif (composés de 2 ms pour la mesure de la tension $V_{S1}$ et 2 ms pour la mesure de la tension $V_{S2}$) pour 46 ms d'intervalle inactif durant lequel le circuit 5 peut effectuer la soustraction et transférer le résultat à l'afficheur 9. Il en résulte une réduction d'un facteur $50/4 = 12{,}5$ de la consommation du montage. Bien entendu, il convient de tenir compte dans la détermination des durées des mesures I et II, des temps de montée des amplificateurs $A_1$ et $A_2$ et du temps que met le convertisseur 4 à effectuer la conversion en une valeur numérique des tensions $V_{S1}$ et $V_{S2}$.

On notera que le montage ne comporte aucune capacité d'isolation qui sont habituellement nécessaires dans les amplificateurs à stabilisation par un chopper.

Il s'est avéré que le montage peut être réalisé avec des composants courants disponibles dans le commerce, que la dérive en température est quasiment nulle et que le taux de rejection en mode commun est élevé.

**Revendications**

1. Montage amplificateur différentiel à courant continu, notamment pour la mesure de faibles tensions variant lentement, du type comportant deux amplificateurs opérationnels en cascade (A1, A2) dont les entrées non inverseuses (a) sont raccordées aux bornes d'entrée du montage, le premier amplificateur (A1) étant rebouclé sur son entrée inverseuse (b), tandis que sa sortie (c) est connectée à l'entrée inverseuse (b) du second amplificateur (A2), celui-ci comprenant une boucle de réaction (3) qui en détermine un gain prédéterminé, caractérisé en ce que les entrées non inverseuses (a) des deux amplificateurs (A1, A2) sont connectées auxdites bornes d'entrée (b1, b2) du montage par l'intermédiaire de moyens de commutation (1) pour permettre sélectivement l'inversion de polarité de cette connexion, et en ce qu'il comprend en outre des moyens (6) pour déterminer des cycles de fonctionnement successifs comprenant un cycle de mesure et un cycle de calcul, une mémoire (7) pour mémoriser pendant chaque cycle de fonctionnement le signal de sortie ($V_{S1}$) du second amplificateur (A2) résultant d'un signal d'entrée reçu dans une première position des moyens de commutation (1) et un circuit de calcul (5) qui reçoit lorsque lesdits moyens de commutation sont dans une seconde position le signal de sortie dudit second amplificateur (A2) pour opérer durant le cycle de calcul, la soustraction du signal mémorisé et du second signal de sortie du second amplificateur (A2), en ce que la sortie (c) dudit second amplificateur (A2) est raccordée auxdits moyens de calcul et à ladite mémoire (7) par l'intermédiaire d'un convertisseur analogique/numérique (4), et en ce que les moyens de calcul et la mémoire sont des composants numériques commandés par une horloge (6).

2. Montage suivant la revendication 1, caractérisé en ce que les moyens (6) pour déterminer le cycle de fonctionnement du montage, sont raccordés également à un circuit de commutation (8) connectés à son tour à une source d'alimentation pour n'alimenter lesdits amplificateurs et éventuellement une source de signaux de mesure que durant ledit cycle de mesure.

3. Montage suivant la revendication 1, caractérisé en ce que ladite horloge (6) comporte lesdits moyens pour déterminer le cycle de fonctionnement du montage.

4. Montage suivant l'une quelconque des revendications 1 à 3, caractérisé en ce que ladite source de mesure est un pont de résistances (C1, C2, R4, R5) dont l'une au moins est un capteur de mesure tel qu'une jauge de contrainte.

5. Montage suivant l'une quelconque des revendications 1 à 4, caractérisé en ce que lesdits moyens de commutation (1) comprennent un inverseur bipolaire, à semi-conducteurs, commandés par lesdits moyens (6) pour déterminer le cycle de fonctionnement du montage.

6. Montage suivant la revendication 5, caractérisé en ce que ledit inverseur bipolaire comprend quatre transistors à effet de champ (i1 à i4).

**Claims**

1. Direct current differential amplifier circuit, particularly for measuring low, slowly varying voltages of the type having two operational amplifiers (A1, A2) in cascade, whereof the non-inverting inputs (a) are connected to the input terminals of the circuit, the first amplifier (A1) being relooped on to its inverting

4

input (b), whilst its output (c) is connected to the inverting input (b) of the second amplifier (A2), the latter having a feedback loop (3) determining a predetermined gain thereof, characterized in that the non-inverting inputs (a) of the two amplifiers (A1, A2) are connected to said input terminals (b1, b2) of the circuit via switching means (1) in order to selectively permit the polarity reversal of said connection, in that it also comprises means (6) for determining the successive operating cycles involving a measuring cycle and a calculating cycle, a memory (7) for storing during each operating cycle the output signal ($V_{S1}$) of the second amplifier (A2) resulting from an input signal received in a first position of the switching means (1) and a calculating circuit (5) which, when said switching means are in a second position, receives the output signal of said second amplifier (A2) in order to operate during the calculating cycle, the subtraction of the stored signal and the second output signal of the second amplifier (A2), in that the outputs (c) of said second amplifier (A2) is connected to said calculating means and to said memory (7) via an analog-digital converter (4) and in that the calculating means and the memory are digital components controlled by a clock (6).

2. Circuit according to claim 1, characterized in that the means (6) for determining the operating cycle of the circuit are also connected to a switching circuit (8) connected in turn to a power supply in order to only supply the amplifiers and possibly a measuring signal source during said measuring cycle.

3. Circuit according to claim 1, characterized in that the clock (6) has means for determining the operating cycle of the circuit.

4. Circuit according to one of the claims 1 to 3, characterized in that the measuring source is a resistor bridge (C1, C2, R4, R5), whereof at least one is a measuring sensor, such as a strain gauge.

5. Circuit according to any one of the claims 1 to 4, characterized in that the switching means (1) incorporate a bipolar inverter with semiconductors controlled by said means (6) for determining the operating cycle of the circuit.

6. Circuit according to claim 5, characterized in that the bipolar inverter comprises four field effect transistors (i1 to i4).


**Patentansprüche**

1. Gleichspannungs-Differenzverstärkerschaltung, insbesondere zur Messung von langsam variierenden schwachen Spannungen, mit zwei kaskadenverschalteten Operationsverstärkern (A1, A2), deren nicht-invertierende Eingänge (a) an die Eingangsklemmen der Schaltung angeschlossen sind, wobei der erste Verstärker (A1) auf seinen invertierenden Eingang (b) zurückgeschleift ist, während sein Ausgang (c) mit dem invertierenden Eingang (b) des zweiten Verstärkers (A2) verbunden ist, wobei dieser eine Rückwirkungsschleife (3) umfaßt, die dadurch eine bestimmte Verstärkung bestimmt, dadurch gekennzeichnet, daß die nichtinvertierenden Eingänge (a) der beiden Verstärker (A1, A2) mit den Eingangsklemmen (b1, b2) der Schaltung über Schaltmittel (1) verbunden sind, die eine ausgewählte Umkehrung der Polarität dieser Verbindung gestatten, und daß sie ferner Mittel (6) zur Bestimmung von aufeinanderfolgenden einen Meßzyklus und einen Rechenzyklus umfassenden Funktionszyklen, einen Speicher (7) zur Speicherung, während eines jeden Funktionszyklusses, des Ausgangssignals ($V_{S1}$) des zweiten Verstärkers (A2), welches sich aus einem in einer ersten Stellung der Schaltmittel (1) erhaltenen Eingangssignal ergibt, und eine Rechenschaltung (5), welche, wenn sich die Schaltmittel in einer zweiten Stellung befinden, das Ausgangssignal des zweiten Verstärkers (A2) für ein Durchführen, während des Rechenzyklusses, der Subtraktion des gespeicherten Signals und des zweiten Ausgangssignals des zweiten Verstärkers (A2) erhält, umfaßt, und daß der Ausgang (c) des zweiten Verstärkers (A2) an die Rechenmittel und den Speicher (7) über einen Analog-Digitalwandler (4) angeschlossen ist, und daß die Rechenmittel und den Speicher durch einen Zeitgeber (6) gesteuerte digitale Komponenten sind.

2. Schaltung nach Anspruch 1, dadurch gekennzeichnet, daß die Mittel (6) zur Bestimmung der Funktionszyklen der Schaltung auch an eine ihrerseits mit einer Spannungsquelle verbundene Umschalt-Schaltung (8) angeschlossen sind, um die Verstärker und ggf. eine Meßsignalquelle nur während des Meßzyklusses mit Spannung zu versorgen.

3. Schaltung nach Anspruch 1, dadurch gekennzeichnet, daß der Zeitgeber (6) die Mittel zur Bestimmung des Funktionszyklusses der Schaltung aufweist.

4. Schaltung nach irgendeinem der Ansprüche 1 bis 3, dadurch gekennzeichnet, daß die Meßquelle eine Brücke aus Widerständen (C1, C2, R4, R5) ist, von denen wenigstens einer ein Meßwertgeber, wie ein Dehnungsmeßstreifen, ist.

5. Schaltung nach irgendeinem der Ansprüche 1 bis 4, dadurch gekennzeichnet, daß die Schaltmittel (1) einen zweipoligen Umschalter auf der Basis von Halbleitern umfaßt, die durch die Mittel (6) zur Bestimmung des Funktionszyklusses der Schaltung gesteuert werden.

6. Schaltung nach Anspruch 5, dadurch gekennzeichnet, daß der bipolare Umschalter vier Feldeffekt-Transistoren (i1 bis i4) umfaßt.

**FIG.1**

## FIG.2